(19) **Europäisches Patentamt**
**European Patent Office**
**Office européen des brevets**

(11) **EP 2 296 171 A2**

(12) **EUROPÄISCHE PATENTANMELDUNG**

(43) Veröffentlichungstag:
16.03.2011 Patentblatt 2011/11

(51) Int Cl.:
*H01L 21/312* *(2006.01)*

(21) Anmeldenummer: 10174650.1

(22) Anmeldetag: 31.08.2010

(84) Benannte Vertragsstaaten:
**AL AT BE BG CH CY CZ DE DK EE ES FI FR GB
GR HR HU IE IS IT LI LT LU LV MC MK MT NL NO
PL PT RO SE SI SK SM TR**
Benannte Erstreckungsstaaten:
**BA ME RS**

(30) Priorität: **10.09.2009 EP 09169916**

(71) Anmelder: **BASF SE**
**67056 Ludwigshafen (DE)**

(72) Erfinder:
• **Czaja, Alexander**
**67246, Dirmstein (DE)**
• **Malkowsky, Itamar Michael**
**67346, Speyer (DE)**
• **Leung, Emi**
**68161, Mannheim (DE)**
• **Müller, Ulrich**
**67435, Neustadt (DE)**

(54) **Verwendung von metallorganischen gerüstmaterialien zur herstellung von mikroelektronischen bauteilen**

(57) Die vorliegende Erfindung betrifft die Verwendung von metallorganischen Gerüstmaterialien, die im Festkörper keine Metall-Metall-Bindungen aufweisen, zur Herstellung von mikroelektronischen Bauteilen. Ferner betrifft die vorliegende Erfindung ein Verfahren zur Herstellung von mikroelektronischen Bauteilen, das dadurch gekennzeichnet ist, dass eine Schicht, bestehend aus metallorganischen Gerüstmaterialien, die im Festkörper keine Metall-Metall-Bindungen aufweisen, auf den zur Herstellung des Bauteils verwendeten Substrat aufgetragen wird.

EP 2 296 171 A2

**Beschreibung**

Die vorliegende Erfindung betrifft die Verwendung von metallorganischen Gerüstmaterialien, die im Festkörper keine Metall-Metall-Bindungen aufweisen, zur Herstellung von mikroelektronischen Bauteilen. Ferner betrifft die vorliegende Erfindung ein Verfahren zur Herstellung von mikroelektronischen Bauteilen, das dadurch gekennzeichnet ist, dass eine Schicht, bestehend aus metallorganischen Gerüstmaterialien, die im Festkörper keine Metall-Metall-Bindungen aufweisen, auf den zur Herstellung des Bauteils verwendeten Substrat aufgetragen wird.

Um die Eigenschaften mikroelektronischer Bauteile zu verbessern, beispielsweise den Stromverbrauch der hochintegrierten Schaltkreise zu verringern oder höhere Schaltgeschwindigkeiten zu erzielen, werden die Bausteine verkleinert. Durch die fortschreitende Miniaturisierung mikroelektronischer Bauteile stößt die Halbleiterindustrie allerdings zunehmend an die physikalischen Grenzen.

Ein Effekt der Miniaturisierung ist die Abstandsverringerung der Metallisierungsschichten, d.h. die Leitbahnschichten für die Verdrahtung der Bauelemente, auf dem Chip. Durch diese Verkleinerung der Isolatordicke zwischen zwei Leitbahnen steigt der Einfluss der parasitären Kapazitäten. Die parasitären Kapazitäten stören die Funktion des Schaltkreises und verringern beispielsweise die maximale Schaltgeschwindigkeit.

Parasitäre Kapazitäten entstehen beispielsweise wenn zwei Leiterbahnen sich auf unterschiedlichen Ebenen kreuzen. Der Kreuzungsbereich gleicht dabei einem einfachen Plattenkondensator. Die Kapazität C eines Plattenkondensators berechnet sich nach:

$$C = \frac{\varepsilon_0 \cdot \varepsilon \cdot A}{d}$$

dabei ist d der Plattenabstand, A die Fläche der Kondensatorplatten, $\varepsilon_0$ die absolute Dielektrizitätskonstante des Vakuums und die Materialkonstante $\varepsilon$ die relative Permittivität der Isolationsschicht.

Es ist zu sehen, dass die Verringerung des Abstandes d die Kapazität C erhöht. Um dies auszugleichen, ist es notwendig, die Plattenfläche A oder die Dielektrizitätskonstante $\varepsilon$ zu verringern. Die Plattenfläche A wird meist nicht verringert, sie ergibt sich aus der Leitbahnbreite und kann bei gleichen Anforderungen, d.h. der zu leitenden Stromdichte, nicht verringert werden.

Am effizientesten wäre es, wenn man kein weiteres Material zwischen den Leiterbahnen einsetzen müsste. Luft hat eine relative Dielektrizitätskonstante $\varepsilon$ von ca. 1. Allerdings muss eine gewisse mechanische Festigkeit vorliegen um die Strukturen der integrierten Schaltung zu stabilisieren. Als Maß hierfür wird das Elastizitätsmodul herangezogen.

Prinzipiell gibt es mehrer Wege zur Verringerung der Dielektrizitätskonstante, beispielsweise durch Senkung der Polarisierbarkeit (Dipolstärke) unter Verwendung von Substanzen mit wenig polaren Bindungen wie C-C, C-H, Si-F und Si-C oder durch Senkung der Materialdichte (Dipoldichte) durch Schaffung von freiem Volumen oder der Ausbildung lokal begrenzter Poren (mikroporöse Schichten).

Als Low-k-Material wird in der Halbleitertechnologie ein Material bezeichnet, das eine niedrigere Dielektrizitätskonstante als $SiO_2$ aufweist, d. h. $\varepsilon < 3{,}9$. Derzeit in der Halbleiterindustrie eingesetzte Low-k-Materialien sind unter anderem durch CVD- oder Spin-on-Verfahren abgeschiedene mikroporöse SiO- und SiOC-Schichten. Als Basismaterialien dienen siliziumorganische Verbindungen, die unter anderem auch im Baustoff- und Beschichtungssektor in großem Umfang eingesetzt werden. Typische Low-k-Vorstufen sind Tetraethylorthosilikat und die methylsubstituierten Silane, Tetramethylsilan und Trimethylsilan.

Die derzeit in integrierten Schaltungen verwendeten Kohlenstoff dotierten Silika-Materialien weisen einen $\varepsilon$-Wert von ungefähr 3,3 auf. Industriell lassen sich bereits Materialien mit einem $\varepsilon$-Wert von ungefähr 2,3 bis 2,7 herstellen. Ein industrielles Verfahren zur Herstellung von Materialien mit einem $\varepsilon$-Wert von kleiner 2.1 ist allerdings bislang unbekannt.

Mikroporöse Low-k-Schichten können beispielsweise durch Beimischen von Porenbildnern und Emulgatoren zur Low-k-Vorstufe erzeugt werden.

Andere Low-k-Materialien sind beipsielsweise Kunststoffe, die aber nicht immer die für den Einsatz in der Halbleitertechnik erforderliche mechanische Festigkeit aufweisen.

Liu et al. beschreibt in Advanced Functional Materials 2008, 18, 1732-1738, ein Verfahren zur Herstellung von MEL-Zeolithen mit einem $\varepsilon$-Wert von 1,9.

EP 1 167 291 B1 schützt die Verwendung von Bornitridschichten als dielektrisches Schichtlagenmaterial mit niedriger Dielektrizitätskonstante. Das Borazin-Material hat eine Dielektrizitätskonstante von 2,3 und widersteht Druck bis etwa 60 Gigapascal, gemessen nach dem Elastizitätsmodul.

Nippon Zeon hat ein Kohlenstoff-Fluorid-Gemisch namens 'Zeomac' mit einer dielektrischen Konstante von 2,2 entwickelt, dessen mechanische Stärke doppelt so hoch wie die von porösen Silikat-Materialien ist. Das Material besitzt eine Ring-Struktur mit der molekularen Formel $C_5F_8$.

Im gesamten Bereich der Low-k-Materialien wird derzeit intensiv geforscht und entwickelt. Als Problem erweist sich, dass die Materialien als dünne Schicht auch die derzeitigen industriellen Anforderungen hinsichtlich Leckstromdichte ($< 10$-9 A/cm) und Durchbruchfeldstärke EBD ($> 3$ MV/cm) erfüllen müssen. Ferner sind die mechanische Stabilität, die chemische Stabilität sowie die Hydrophobität der Materialien von großer Bedeutung.

Durch den Einsatz von Low-k-Materialien kann demnach die parasitäre Kapazität der Kupferverbindungen minimiert werden und folglich kann die Verlustleistung beim Schalten von Signalen gesenkt werden, was den Leistungsbedarf des Chips senken kann oder eine Steigerung der Taktfrequenz erlaubt. Außerdem lassen sich durch verringertes Übersprechen zwischen benachbarten Leitungen Funktionsblöcke dichter packen.

Eine der Herausforderungen bei der Entwicklung der nächsten Generation von Mikroprozessoren ist daher die Verfügbarkeit von Materialien mit geringer Dielektrizitätskonstante ε. Durch diese Materialien wird sowohl Signallaufzeitverzögerung, Leistungsaufnahme und Übersprechen zwischen Leiterbahnen bestimmt. Generell erlauben Low-k Materialen schnellere Schaltzeiten und geringere Verlustleistung durch kleinere parasitäre Kapazitäten. Angestrebt werden heutzutage sogenannte Ultra-Low-k-Materialien, deren Dielektrizitätszahl kleiner als 2,4 ist.

Trotz der genannten Erfolge bei der Suche nach Low-k-Materialien besteht weiterhin, insbesondere bei der Entwicklung von Mikroprozessoren nächster Generation, ein Bedarf an Materialien, die Low-k-Dielektrika-Eigenschaften, bevorzugt Ultra-Low-k-Dielektrika-Eigenschaften aufweisen.

Die Aufgabe der vorliegenden Erfindung bestand somit darin Materialien aufzuzeigen, die Low-k-Dielektrika-Eigenschaften, bevorzugt Ultra-Low-k-Dielektrika-Eigenschaften aufweisen und ferner geeignete mechanische und chemische Stabilität, sowie entsprechende Hydrophobität aufweisen.

Überraschenderweise wurde gefunden, dass metallorganischen Gerüstmaterialien (MOF), die im Festkörper keine durchgängigen Metall-Metall-Bindungen aufweisen, zur Herstellung von mikroelektronischen Bauteilen und Isoliermaterialien in der Mikroelektronik geeignet sind.

Durchgängig Metall-Metall-Bindungen bezeichnen in diesem Zusammenhang eine durchgängige, ununterbrochene Spur von Metall Atomen durch den MOF-Kristall, deren Abstände den üblicherweise angenommenen Abständen für entsprechende Metall-Metall-Bindungen entsprechen oder darunter liegen. Im Gegensatz dazu sind isolierte Metall-Metall-Bindungen zu sehen, welche keine durchgängige, ununterbrochene Spur von Metal Atomen darstellen, sondern nur periodische und daher isolierte Metall-Metall-Bindungen nahelegen. Dies ist rein phänomenologisch und unabhängig davon zu sehen, ob tatsächlich einen physikalisch-chemische Metall-Metall-Bindung vorliegt.

Poröse metallorganische Gerüstmaterialien sind im Stand der Technik bekannt. Beispielsweise werden MOFs in US 5,648,508, EP-A-0 790 253, M. O'Keeffe et al., J. Sol. State Chem., 152 (2000), Seite 3 bis 20, H. Li et al., Nature 402 (1999), Seite 276, M. Eddaoudi et al., Topics in Catalysis 9 (1999), Seite 105 bis 111, B. Chen et al., Science 291 (2001), Seite 1021 bis 1023, DE-A-101 11 230 und in A.C. Sudik, et al., J. Am. Chem. Soc. 127 (2005), 7110-7118 beschrieben.

Metallorganische Gerüstmaterialien enthalten üblicherweise eine oder mehrere, bevorzugt eine oder zwei an ein oder mehrere Metallion(en), bevorzugt zwei bis sechs Metallionen, besonders bevorzugt zwei, vier oder sechs Metallionen koordinativ gebundene, mindestens zweizählige organische Verbindung(en), die gemeinsam mit den Metallionionen das Gerüst des metallorganischen Gerüstmaterials darstellt.

Der Begriff "Metall", wie im Rahmen der vorliegenden Erfindung im Bezug auf die metallorganische Gerüstmaterialien verwendet wird, umfasst sämtliche Elemente des Periodensystems, die mit mindestens einer mindestens zweizähnigen organischen Verbindung mindestens ein metallorganisches poröses Gerüstmaterial zu bilden in der Lage sind.

Bevorzugt werden im Rahmen der vorliegenden Erfindung Metallionen der Gruppen IIa, IIIa, IVa, Va, Ib bis VIIIb des Periodensystems der Elemente, sowie der Gruppe der Lanthanoiden eingesetzt. Besonders bevorzugte Strukturen des metallorganischen Gerüstmaterials beruhen auf Metallionen ausgewählt aus der Gruppe bestehend aus Aluminium, Magnesium, Calcium, Strontium, Barium, Indium, Germanium, Gallium, Yttrium, Lanthan, Cer, sowie sonstige Lanthanoide, Eisen, Zink, Nickel, Kobalt, Vanadium, Chrom, Mangan und Kupfer. Weiter bevorzugt beruht das metallorganische Gerüstmaterial auf Metallionen ausgewählt aus der Gruppe bestehend aus Aluminium, Magnesium, Calcium, Yttrium, Lanthan, Cer, Zink und Mangan, Kupfer, Eisen, Indium, Nickel, Cobalt, Vanadium. Insbesondere beruht das metallorganische Gerüstmaterial auf Metallionen ausgewählt aus der Gruppe bestehend aus Aluminium, Magnesium, Kupfer, Indium, Eisen, Zink, Yttrium.

Der Begriff "mindestens zweizähnige organische Verbindung", wie er im Rahmen der vorliegenden Erfindung verwendet wird, bezeichnet eine organische Verbindung, die mindestens eine funktionelle Gruppe enthält, die in der Lage ist, zu einem gegebenen Metallion mindestens zwei Bindungen, und/oder zu zwei oder mehr Metallatomen jeweils eine oder mehrere koordinative Bindungen auszubilden.

Als funktionelle Gruppen, über die die genannten koordinativen Bindungen ausgebildet werden können, sind insbesondere beispielsweise folgende funktionellen Gruppen zu nennen: $-CO_2H$, $-CS_2H$, $-NO_2$, $-B(OH)_2$, $-SO_3H$, $-Si(OH)_3$, $-Ge(OH)_3$, $-Sn(OH)_3$, $-Si(SH)_4$, $-Ge(SH)_4$, $-Sn(SH)_3$, $-PO_3H$, $-AsO_3H$, $-AsO_4H$, $-P(SH)_3$, $-As(SH)_3$, $-CH(RSH)_2$, $-C(RSH)_3$, $-CH(RNH_2)_2$, $-C(RNH_2)_3$, $-CH(ROH)_2$, $-C(ROH)_3$, $-CH(RCN)_2$, $-C(RCN)_3$, wobei R beispielsweise bevorzugt eine Alkylengruppe mit 1, 2, 3, 4 oder 5 Kohlenstoffatomen wie beispielsweise eine Methylen-, Ethylen-, n-Propylen-, i-Propylen, n-Butylen-, i-Butylen-, tert-Butylen- oder n-Pentylengruppe, oder eine Arylgruppe, enthaltend einen oder mehrere, bevorzugt ein, zwei oder drei aromatische Kerne wie beispielsweise 2 $C_6$-Ringe, die gegebenenfalls

kondensiert sein können und unabhängig voneinander mit mindestens jeweils einem Substituenten geeignet substituiert sein können, und/oder die unabhängig voneinander jeweils mindestens ein Heteroatom wie beispielsweise N, O und/oder S enthalten können, bedeutet. Gemäß ebenfalls bevorzugter Ausführungsformen sind funktionelle Gruppen zu nennen, bei denen der oben genannte Rest R nicht vorhanden ist. Diesbezüglich sind unter anderem $-CH(SH)_2$, $-C(SH)_3$, $-CH(NH_2)_2$, $-C(NH_2)_3$, $-CH(OH)_2$, $-C(OH)_3$, $-CH(CN)_2$ oder $-C(CN)_3$ zu nennen.

Bei mindestens zwei funktionellen Gruppen kann jede weitere Gruppe grundsätzlich an jede geeignete organische Verbindung gebunden sein, solange gewährleistet ist, dass die diese funktionellen Gruppen aufweisende organische Verbindung zur Ausbildung der koordinativen Bindung und zur Herstellung des Gerüstmaterials befähigt ist.

Bevorzugt leiten sich die organischen Verbindungen, die die mindestens zwei funktionellen Gruppen enthalten, von einer gesättigten oder ungesättigten aliphatischen Verbindung oder einer aromatischen Verbindung oder einer sowohl aliphatischen als auch aromatischen Verbindung ab.

Die aliphatische Verbindung oder der aliphatische Teil der sowohl aliphatischen als auch aromatischen Verbindung kann linear und/oder verzweigt und/oder cyclisch sein, wobei auch mehrere Cyclen pro Verbindung möglich sind. Weiter bevorzugt enthält die aliphatische Verbindung oder der aliphatische Teil der sowohl aliphatischen als auch aromatischen Verbindung 1 bis 15, weiter bevorzugt 1 bis 14, weiter bevorzugt 1 bis 13, weiter bevorzugt 1 bis 12, weiter bevorzugt 1 bis 11 und insbesondere bevorzugt 1 bis 10 C-Atome wie beispielsweise 1, 2, 3, 4, 5, 6, 7, 8, 9 oder 10 C-Atome. Insbesondere bevorzugt sind hierbei unter anderem Methan, Adamantan, Acetylen, Ethylen oder Butadien.

Die aromatische Verbindung oder der aromatische Teil der sowohl aromatischen als auch aliphatischen Verbindung kann einen oder auch mehrere Kerne wie beispielsweise zwei, drei, vier oder fünf Kerne aufweisen, wobei die Kerne getrennt voneinander und/oder mindestens zwei Kerne in kondensierter Form vorliegen können. Besonders bevorzugt weist die aromatische Verbindung oder der aromatische Teil der sowohl aliphatischen als auch aromatischen Verbindung einen, zwei oder drei Kerne auf, wobei einer oder zwei Kerne besonders bevorzugt sind. Unabhängig voneinander kann weiter jeder Kern der genannten Verbindung mindestens ein Heteroatom wie beispielsweise N, O, S, B, P, Si, Al, bevorzugt N, O und/oder S enthalten. Weiter bevorzugt enthält die aromatische Verbindung oder der aromatische Teil der sowohl aromatischen als auch aliphatischen Verbindung einen, zwei oder vier $C_6$-Kerne, wobei die zwei entweder getrennt voneinander oder in kondensierter Form vorliegen. Insbesondere sind als aromatische Verbindungen Benzol, Naphthalin und/oder Biphenyl und/oder Bipyridyl und/oder Pyridin zu nennen.

Bevorzugte mindestens zweizähnige organische Verbindungen sind Terephthalsäure, Aminoterephthalsäure, Hydroxy- und Dihydroxyterephthalsäure, Methoxy- und Dimethoxyterephthalsäure, Isophthalsäure, tert.-Butylisophthalsäure, 2,6- und 1,5- Naphthalindicarbonsäure, Fumarsäure, Glutarsäure, Tetrazol, 2-Methylimidazol, Imidazol, Pyridindicarbonsäure, Bezol-1,3,5-tricarbonsäure, Biphenyl-4,4'-dicarbonsäure, 2,2'-Bipyrdin-4,4'-dicarbonsäure, 2,2'-Bipyrimidin-4,4'-dicarbonsäure und deren Isomere und deren Substitutionsprodukte mit $NR_2$, OR, SR und/oder R wobei R für aliphatische oder aromatische Reste steht, Ameisensäure, 4,5- Imidazoldicarbonsäure oder Malonsäure. Besonders bevorzugt werden Terephthalsäure, Benzol-1,3,5-tricarbonsäure, Fumarsäure, 2-Methylimidazol und deren Isomere und Substitutionsprodukte, insbesondere Trerephthalsäure und Benzol-1,3,5-tricarbonsäure und deren Isomere und Substitutionsprodukte.

Bevorzugte aliphatische Reste sind geradkettige und verzweigte Alkylgruppen. Vorzugsweise handelt es sich dabei um geradkettige oder verzweigte $C_1$-$C_{20}$-Alkyl, bevorzugterweise $C_1$-$C_{12}$-Alkyl-, besonders bevorzugt $C_1$-$C_8$-Alkyl- und ganz besonders bevorzugt $C_1$-$C_4$-Alkylgruppen. Beispiele für Alkylgruppen sind insbesondere Methyl, Ethyl, Propyl, Isopropyl, n-Butyl, 2-Butyl, sec.-Butyl, tert.-Butyl, n-Pentyl, 2-Pentyl, 2-Methylbutyl, 3-Methylbutyl, 1,2-Dimethylpropyl, 1,1-Dimethylpropyl, 2,2-Dimethylpropyl, 1-Ethylpropyl, n-Hexyl, 2-Hexyl, 2-Methylpentyl, 3-Methylpentyl, 4-Methylpentyl, 1,2-Dimethylbutyl, 1,3-Dimethylbutyl, 2,3-Dimethylbutyl, 1,1-Dimethylbutyl, 2,2-Dimethylbutyl, 3,3-Dimethylbutyl, 1,1,2-Trimethylpropyl, 1,2,2-Trimethylpropyl, 1-Ethylbutyl, 2-Ethylbutyl, 1-Ethyl- 2-methylpropyl, n-Heptyl, 2-Heptyl, 3-Heptyl, 2-Ethylpentyl, 1-Propylbutyl, n-Octyl, 2-Ethylhexyl, 2-Propylheptyl, Nonyl, Decyl.

Bevorzugte aromatische Reste sind unsubstituierte als auch substituierte Arylgruppen, und steht vorzugsweise für Phenyl, Tolyl, Xylyl, Mesityl, Naphthyl, Fluorenyl, Anthracenyl, Phenanthrenyl oder Naphthacenyl, besonders bevorzugt für Phenyl oder Naphthyl, wobei diese Arylgruppen im Falle einer Substitution im Allgemeinen 1, 2, 3, 4 oder 5, vorzugsweise 1, 2 oder 3 und besonders bevorzugt 1 Substituenten, ausgewählt aus den Gruppen Alkyl, Alkoxy, Carboxylat, Trifluormethyl, Sulfonat, $NE^1E^2$, Alkylen-$NE^1E^2$, Nitro, Cyano oder Halogen, tragen können. Eine bevorzugte Perfluorarylgruppe ist Pentafluorphenyl.

Bevorzugte MOF-Strukturen sind Al-Terephthalat, Y-BDC, Al-NDC, Al-Fumarat, Al-Aminoterephthalsäure, Y-NDC, Zn-2-Methylimidazol, Zn-2-Ethylimidazol, Mg-Formiat, Mn-Formiat, Mg-NDC, Cu-BTC, Cu-Imidazole, Ln-BTC, Y-Imidazoldicarbonsäure, Al-Biphenyl-4,4'-dicarboxylat, sowie Zn-2-hydroxy-therephthalat.

Dabei gelten folgende Abkürzungen:

BDC     Benzoldicarbonsäure
NDC     Naphthalindicarbonsäure

BTC    Benzoltricarbonsäure

Das metallorganische Gerüstmaterial enthält typischerweise Poren, insbesondere Mikro- und/oder Mesoporen. Mikroporen sind definiert als solche mit einem Durchmesser von 2 nm oder kleiner und Mesoporen sind definiert durch einen Durchmesser im Bereich von 2 bis 50 nm, jeweils entsprechend nach der Definition, wie sie in Pure Applied Chemistry 57 (1985), Seiten 603 - 619, insbesondere auf Seite 606 angegeben ist. Die Anwesenheit von Mikro- und/oder Mesoporen kann mit Hilfe von Sorptionsmessungen überprüft werden, wobei diese Messungen die Aufnahmekapazität der metallorganischen Gerüstmaterialien für Stickstoff bei 77 K gemäß DIN 66131 und/oder DIN 66134 bestimmt.

Vorzugsweise besitzt das metallorganische Gerüstmaterial einen durchschnittlichen Porendurchmesser von 0,5 bis 10 nm, besonders bevorzugt von 0,8 bis 9 nm. Insbesondere ist bevorzugt, dass die Verteilung der Porengröße maximal +/- 5 nm beträgt. Weiterhin bevorzugt liegt der am häufigsten auftretende Porendurchmesser in einem Bereich von 0,8 bis 9 nm.

Die MOF Strukturen können nach allen dem Fachmann bekannten Herstellweisen hergestellt werden. Neben der konventionellen Herstellmethode, wie diese beispielsweise in US 5,648,508 beschrieben wird, können die MOF Strukturen auch auf elektrochemischem Wege hergestellt werden, wie beispielsweise in DE-A 103 55 087 und WO-A 2005/049892 beschrieben.

Die metallorganischen Gerüstmaterialien weisen vorteilhaft eine Dielektrizitätskonstante von kleiner gleich 3,9 auf, bevorzugt kleiner gleich 3, insbesondere kleiner gleich 2,4. Bevorzugt liegt die Dielektrizitätskonstante in einem Bereich von 1 bis 4, insbesondere 1,1 bis 3. Beispielsweise weist Zn-2-Methylimidazolat eine Dielektrizitätskonstante im Bereich von 1,4 bis 2,0 auf; Cu-1,3,5-Benzoltricarboxylat weist eine Dielektrizitätskonstante im Bereich von 2,0 bis 3,9 auf.

Bevorzugt werden elektrochemisch stabile MOFs verwendet, bevorzugt werden MOFs auf Basis on Al, Mg, Cu und/oder Zn verwendet.

Bevorzugt kann die Erfindung zur Herstellung von Logikbausteinen eingesetzt werden, besonders bevorzugt zur Herstellung von Mikroprozessoren.

Ferner betrifft die vorliegende Erfindung ein Verfahren zur Herstellung von mikroelektronischen Bauteilen, das dadurch gekennzeichnet ist, dass eine Schicht, bestehend aus metallorganischen Gerüstmaterialien, die im Festkörper keine Metall-Metall-Bindungen aufweisen, auf den zur Herstellung des Bauteils verwendeten Substrat aufgetragen wird.

Unabhängig von der Art der Herstellung können die metallorganischen Gerüstmaterialien

    a) in einem separaten Produktionsprozess oder
    b) direkt auf dem gewünschten Substrat hergestellt werden.

Im Fall (a) werden die metallorganischen Gerüstmaterialien nach den dem Fachmann bekannten hydrothermalen oder elektrochemischen Verfahren hergestellt, formuliert und in einem zusätzlichen Prozessschritt nach allen dem Fachmann bekannten Methoden auf das Substrat aufgebracht. Beispielsweise kann dieser Schritt mit Hilfe von Spin-Coating oder Siebdruck mit einer Dispersion, die metallorganischen Gerüstmaterialien enthält, durchgeführt werden.

Im Fall (b) werden die metallorganischen Gerüstmaterialien direkt auf dem Subtrat, d.h. dem späteren technischen Bauteil, hergestellt. Diese direkte Synthese des MOFs auf der Oberfläche kann wiederum mittels hydrothermaler oder elektrochemischer Verfahren erfolgen. Beispielsweise können die metallorganischen Gerüstmaterialien durch in situ Kristallisation auf dem Substrat erzeugt werden.

Als Substrate (d.h. dem späteren Prozessor) wird beispielsweise ein Wafer eingesetzt.

Der in den Fällen (a) und (b) beschriebene Fertigungsschritt kann vorteilhaft in die bestehende Produktion eines mikroelektronischen Bauteils integriert werden.

**Patentansprüche**

1.    Verwendung von metallorganischen Gerüstmaterialien, die im Festkörper keine Metall-Metall-Bindungen aufweisen, zur Herstellung von mikroelektronischen Bauteilen.

2.    Verwendung nach Anspruch 1, wobei das metallorganische Gerüstmaterial eine oder mehrere an ein oder mehrere Metallion(en), koordinativ gebundene, mindestens zweizähnige organische Verbindung (en), die gemeinsam mit dem Metallion das Gerüst des metallorganischen Gerüstmaterials darstellt, enthält und das Metallion ausgwählt ist aus der Gruppe bestehend aus Aluminium, Magnesium, Kupfer, Indium, Eisen, Zink und Yttrium.

3.    Verwendung nach Anspruch 1, wobei das Metallion ausgewählt ist aus der Gruppe bestehend aus Aluminium, Magnesium, Zink und Kupfer.

4.    Verwendung nach den Ansprüchen 1 bis 3, wobei die mindestens zweizähnige organische Verbindung (en) ausgewählt sind aus der Gruppe bestehend aus Terephthalsäure, Benzol-1,3,5-tricarbonsäure, Fumarsäure, 2-Methylimidazol, Biphenyl-4,4'-dicarbonsäure und deren Isomere und Substitutionsprodukte.

5.    Verwendung nach den Ansprüchen 1 bis 4, wobei das metallorganisches Gerüstmaterial ausgewählt ist aus der Gruppe bestehend aus Al-Terephthaltat, Al-Fumarat, Al-Biphenyl-4,4'-dicarbonsäure, Zn-2-Methylimidazolat, Mg-Formiat oder Zn-2-hydroxy-therephthalat und Cu-1,3,5-benzoltricarboxylat

6. Verfahren zur Herstellung von mikroelektronischen Bauteilen, **dadurch gekennzeichnet, dass** eine Schicht, bestehend aus metallorganischen Gerüstmaterialien, die im Festkörper keine Metall-Metall-Bindungen aufweisen, auf den zur Herstellung des Bauteils verwendeten Substrat aufgetragen wird.

7. Verfahren nach Anspruch 6, **dadurch gekennzeichnet, dass** die metallorganischen Gerüstmaterialien

    a) in einem separaten Produktionsprozess oder
    b) direkt auf dem gewünschten Substrat hergestellt werden.

8. Verfahren nach Anspruch 7, **dadurch gekennzeichnet, dass** im Fall (a) die metallorganischen Gerüstmaterialien nach einem hydrothermalen oder elektrochemischen Verfahren hergestellt, formuliert und in einem zusätzlichen Prozessschritt auf das Substrat aufgebracht werden.

9. Verfahren nach Anspruch 7, **dadurch gekennzeichnet, dass** die metallorganischen Gerüstmaterialien direkt auf der Oberfläche des Substrats mittels hydrothermaler oder elektrochemischer Verfahren hergestellt werden.

10. Verfahren nach den Ansprüchen 6 bis 9, **dadurch gekennzeichnet, dass** als Substrat ein Wafer verwendet wird.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1167291 B1
- US 5648508 A
- EP 0790253 A
- DE 10111230 A
- DE 10355087 A
- WO 2005049892 A

**In der Beschreibung aufgeführte Nicht-Patentliteratur**

- **Liu et al.** *Advanced Functional Materials,* 2008, vol. 18, 1732-1738
- **M. O'Keeffe et al.** *J. Sol. State Chem.,* 2000, vol. 152, 3-20
- **H. Li et al.** *Nature,* 1999, vol. 402, 276
- **M. Eddaoudi et al.** *Topics in Catalysis,* 1999, vol. 9, 105-111
- **B. Chen et al.** *Science,* 2001, vol. 291, 1021-1023
- **A.C. Sudik et al.** *J. Am. Chem. Soc.,* 2005, vol. 127, 7110-7118
- *Pure Applied Chemistry,* 1985, vol. 57, 603-619